Europäisches Patentamt

European Patent Office

Office européen des brevets

(19)

(11) Numéro de publication: **0 155 875**

**A1**

(12) # DEMANDE DE BREVET EUROPEEN

(21) Numéro de dépôt: 85400333.2

(22) Date de dépôt: 22.02.85

(51) Int. Cl.⁴: **H 01 J 37/317**
H 01 J 37/05, H 05 H 3/02

(30) Priorité: 28.02.84 FR 8403028

(43) Date de publication de la demande:
25.09.85 Bulletin 85/39

(84) Etats contractants désignés:
CH DE GB LI

(71) Demandeur: **COMMISSARIAT A L'ENERGIE ATOMIQUE Etablissement de Caractère Scientifique Technique et Industriel**
**31/33, rue de la Fédération**
**F-75015 Paris(FR)**

(72) Inventeur: **Bruel, Michel**
**Presvert No. 9**
**F-38113 Veurey(FR)**

(72) Inventeur: **Biasse, Béatrice**
**Résidence l'Orée du Parc**
**F-38410 Uriage(FR)**

(72) Inventeur: **Cartier, Anne-Marie**
**Le Genevrey**
**F-38450 VIF(FR)**

(74) Mandataire: **Mongrédien, André et al,**
**c/o BREVATOME 25, rue de Ponthieu**
**F-75008 Paris(FR)**

(54) **Dispositif de production d'ions d'une espèce déterminée utilisant pour les séparer d'autres ions, une sélection en énergie, application à l'implantation ionique.**

(57) Le dispositif comprend des moyens (3) pour créer un faisceau d'ions isoénergétiques comprenant des ions qui contiennent une espèce déterminée et sont aptes à se décomposer en donnant des ions constitués de l'espèce ionisée, des moyens (4) pour interagir préférentiellement avec les ions contenant l'espèce et décomposer ceux-ci en faisant apparaître les ions constitués de l'espèce ionisée, et des moyens (5) pour effectuer une séparation énergétique entre les ions constitués de l'espèce ionisée et le reste du faisceau.

EP 0 155 875 A1

./...

FIG. 1

Dispositif de production d'ions d'une espèce déterminée, utilisant pour les séparer d'autres ions, une sélection en énergie, application à l'implantation ionique.

La présente invention concerne un dispositif de production d'ions d'une espèce déterminée, utilisant pour les séparer d'autres ions, une sélection en énergie. Elle s'applique notamment à l'implantation ionique.

On sait que l'implantation ionique permet d'introduire des "impuretés" dans un substrat de façon très sélective, c'est-à-dire en séparant de façon très précise ces "impuretés" d'autres particules sans intérêt, voire gênantes, pour l'implantation à réaliser. Pour ce faire, on utilise des dispositifs de sélection isotopique de masse qui permettent par exemple d'extraire des ions $^{11}B^+$, qui sont ensuite envoyés sur le substrat à doper, d'un faisceau comprenant, outre les ions précédents, des ions parasites ou inintéressants tels que $F^+$, $N^+$, $O^+$, $H^+$...

Ces dispositifs comportent des aimants de déflexion qui impliquent généralement pour ces dispositifs les inconvénients suivants : leur consommation de puissance électrique est élevée, ils occupent une place importante, ont une structure "multipotentiels" et nécessitent des systèmes de tranfert d'énergie électrique (transformateurs d'isolement, boucles de fluides caloporteurs électriquement isolants) ainsi que des systèmes de télécommande et de télétransmission.

Par ailleurs, pour implanter des ions $^{11}B^+$, il est connu d'utiliser une source d'ions qui est alimentée en $BF_3$ et de laquelle on extrait un faisceau d'ions tels que $^{10}B^+$, $^{11}B^+$, $^{10}BF^+$, $^{11}BF^+$, $^{10}BF_2^+$,

B 8145.3 PV

$^{11}BF_2{}^+$. On sélectionne alors généralement les ions $^{11}B^+$ par séparation isotopique de masse. Cependant, dans certains cas particuliers, on préfère sélectionner les ions $^{11}BF_2{}^+$ pour les raisons suivantes :

- ils contiennent bien entendu du bore,
- l'énergie de l'atome $^{11}B$ présent dans l'ion moléculaire $^{11}BF_2{}^+$ n'est que de l'ordre du cinquième de l'énergie de cet ion moléculaire, ce qui permet de réaliser aisément des implantations dans lesquelles l'énergie de l'atome $^{11}B$ est très faible, et
- contrairement à l'implantation d'ions $B^+$, l'implantation de $BF_2{}^+$ dans un substrat en silicium peut rendre celui-ci amorphe, ce qui permet un recuit plus efficace de ce substrat.

Mais cette utilisation d'ions $BF_2{}^+$ pose un problème pratiquement insoluble car, par interaction avec d'autres particules, par exemple les molécules du vide résiduel dans l'implanteur d'ions, même lorsque ce vide est de l'ordre de $10^{-4}$Pa, ces ions $BF_2{}^+$ se décomposent facilement suivant une réaction du type

$$BF_2{}^+ \longrightarrow B^+ + X$$

où X peut représenter $F_2$, $F$, $F^+$... En effet, la section efficace de la réaction ci-dessus est très élevée, de l'ordre de $10^{-15}$cm$^2$.

La présente invention a pour but de remédier aux inconvénients mentionnés plus haut, en proposant un dispositif de production d'ions d'une espèce déterminée, qui utilise pour les séparer d'autres ions, une sélection en énergie et dans lequel on cherche à provoquer une réaction de décomposition du genre de celle qui est considérée plus haut, contrairement à ce que l'on fait dans l'art antérieur.

De façon précise, la présente invention a pour objet un dispositif de production d'ions d'une espèce déterminée, caractérisé en ce qu'il comprend :

- des moyens-source, prévus pour créer un faisceau d'ions isoénergétiques comprenant des ions qui contiennent l'espèce déterminée et sont aptes à se décomposer en donnant des ions constitués de l'espèce déterminée sous forme ionisée,

- des moyens de décomposition, prévus pour interagir préférentiellement avec les ions contenant l'espèce déterminée et décomposer ceux-ci en faisant apparaître les ions constitués de l'espèce déterminée sous forme ionisée, et

- des moyens séparateurs, prévus pour effectuer une séparation énergétique entre les ions constitués de l'espèce déterminée sous forme ionisée et le reste du faisceau.

A titre explicatif et nullement limitatif, l'espèce déterminée est le bore et les ions contenant cette espèce sont les ions $BF_2^+$.

La présente invention présente, par rapport à l'art antérieur, les avantages suivants :

- au lieu d'une sélection isotopique de masse, elle utilise une sélection énergétique, aisément réalisable par exemple à l'aide de filtres électrostatiques qui ne consomment que peu d'énergie électrique et n'ont qu'un faible encombrement,

- elle peut permettre de réaliser un flux d'ions de basse énergie et également un faisceau de particules de plus grande énergie, ce qui est très intéressant pour l'implantation ionique dans le domaine de l'intégration à très grande échelle (VLSI) et

- dans le cas de l'implantation de bore, elle permet de réaliser un gain de courant utilisable car le pic correspondant à $BF_2^+$ dans le spectre d'un grand nombre de sources d'ions est le plus intense, le faisceau $B^+$ séparé suivant la présente invention et provenant des ions $BF_2^+$ étant donc plus intense que le faisceau d'ions $B^+$ directement extrait de la source.

B 8145.3 PV

Selon un mode de réalisation particulier du dispositif objet de l'invention, les moyens de décomposition comprennent un gaz à basse pression ou un plasma, contenu dans un domaine traversé par le faisceau d'ions. Le gaz est par exemple de l'argon et par "basse pression", on entend une pression de l'ordre de quelques centièmes à quelques dixièmes de pascal.

Selon un autre mode de réalisation particulier, les moyens de décomposition comprennent un flux de particules, dirigé vers le faisceau d'ions. Par "particules", on entend dans le cas présent des atomes, des molécules, des ions (négatifs ou positifs), des électrons ou des photons (par exemple des photons ultraviolets, X ou γ).

Selon un autre mode de réalisation particulier, les moyens séparateurs comprennent au moins un filtre électrostatique.

Enfin, selon un autre mode de réalisation particulier, les moyens séparateurs comprennent au moins un filtre à champs électrique et magnétique.

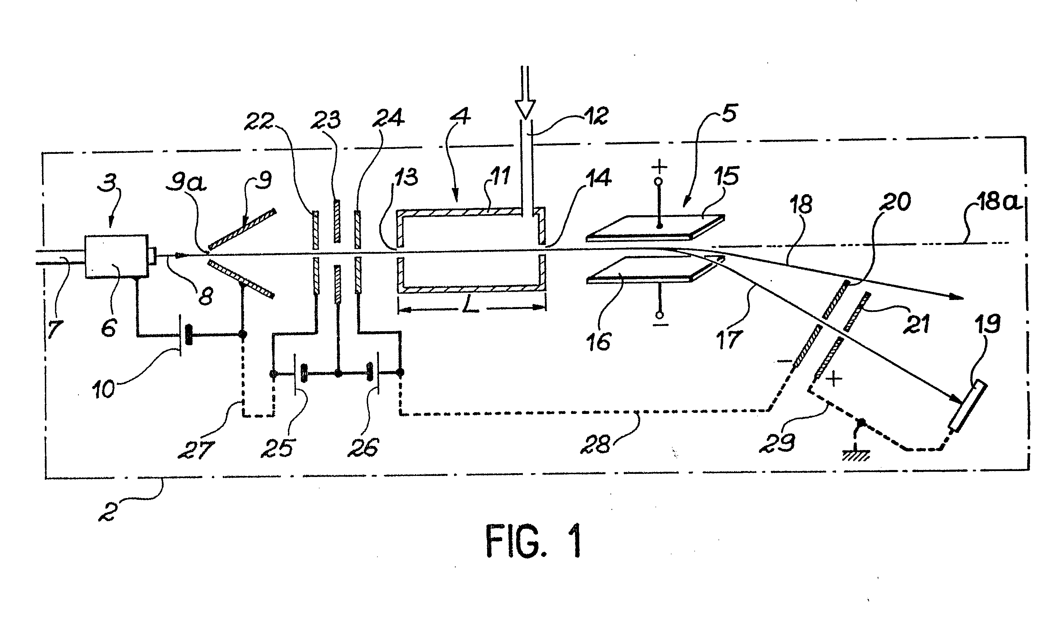

L'invention sera mieux comprise à la lecture de la description qui suit, d'exemples de réalisation donnés à titre indicatif et nullement limitatif, en référence aux dessins annexés sur lesquels les figures 1 à 6 sont des vues schématiques de modes de réalisation particuliers du dispositif objet de l'invention, dans lesquels on utilise respectivement en tant que moyens de décomposition un gaz, un plasma, un flux de photons X ou γ, un flux lumineux, un faisceau d'électrons et un faisceau d'ions.

Sur la figure 1, on a représenté schématiquement un mode de réalisation particulier du dispositif objet de l'invention. Ce dispositif est placé dans une enceinte 2 dans laquelle on a fait le vide à l'aide de moyens de pompages non représentés, et comprend essentiellement des moyens-source 3, des moyens de décomposition 4 et des moyens séparateurs 5 dont la structure et la fonction sont expliquées ci-après, en prenant l'exemple de la production d'ions $B^+$.

Les moyens-source 3 comprennent une source d'ions 6 connue dans l'état de la technique et alimen-tée en $BF_3$ par un conduit 7, de manière à produire un faisceau 8 constitué d'ions $B^+$, d'ions $BF_2^+$ et de di-verses impuretés secondaires ionisées. Les moyens-source 3 comprennent également une électrode 9 prévue pour accélérer le faisceau 8 à sa sortie de la source 6. L'électrode 9 est percée d'une ouverture 9a pour permettre le passage de ce faisceau et portée à un potentiel négatif, par exemple de l'ordre de -25 kV, par rapport à la source d'ions 6, au moyen d'un générateur de tension continue 10.

Les moyens de décomposition 4 sont constitués par un gaz tel que l'argon, à une pression de l'ordre de quelques dixièmes de pascal, contenu dans une chambre 11 qui est alimentée en argon au moyen d'un conduit 12 et pourvue de deux ouvertures 13 et 14 situées en regard l'une de l'autre sur deux côtés opposés de la chambre 11, ces deux ouvertures étant disposées de manière à se trouver sur la trajectoire du faisceau 8 à sa sortie de l'électrode 9, l'ouverture 9a de cette dernière étant ainsi alignée avec les ouvertures 13 et 14 de la chambre 11. On choisit bien entendu les dimensions des ouvertures 13 et 14 pour que celles-ci soient traversables par le faisceau d'ions 8.

A sa sortie de l'électrode d'accélération 9, ce faisceau d'ions 8 est pratiquement isoénergétique, les ions qui le composent étant pour la plupart simplement chargés et ayant ainsi une énergie $E_0$ sensi-blement égale à 25 keV du fait du potentiel de l'élec-

B 8145.3 PV

trode 9.

Dans l'enceinte 11, les ions $BF_2^+$ du faisceau 8 sont pratiquement les seuls à interagir avec les atomes d'argon, suivant la réaction de décomposition rappelée ci-dessus, car la section efficace de décomposition des ions $BF_2^+$ est très grande, de l'ordre de $10^{-15}$ $cm^2$, alors que les sections efficaces concernant les collisions ions-atomes sont généralement de l'ordre de $10^{-16}$ $cm^2$. Il en résulte d'une part que les collisions des ions $BF_2^+$ sont des collisions à grands paramètres d'impacts, au cours desquelles il n'y a pour ainsi dire aucun transfert d'énergie cinétique aux atomes d'argon heurtés et d'autre part que pendant la traversée de la chambre 11, les particules du faisceau 8 autres que les ions $BF_2^+$, n'interagissent pratiquement pas avec les atomes d'argon, car les sections efficaces de collision de ces particules sont de l'ordre de $10^{-16}$ $cm^2$.

Par conséquent, à la sortie de la chambre 11, le faisceau 8 comprend deux groupes d'ions :

- un premier groupe formé d'ions $B^+$ qui résultent de la décomposition des ions $BF_2^+$ dans la chambre, ces ions $B^+$ ayant une énergie bien définie $\alpha E_0$, sensiblement égale à 5 keV pour les ions $^{10}B^+$ et $^{11}B^+$, puisque le coefficient $\alpha$ est égal au rapport de la masse atomique de l'isotope du bore considéré, à la masse atomique du composé $BF_2$ correspondant (48 ou 49), et vaut donc sensiblement 0,2, et

- un second groupe constitué par les ions $BF_2^+$ n'ayant pas interagi avec les atomes d'argon et conservant l'énergie $E_0$, ainsi que par les ions $B^+$ et les impuretés secondaires ionisées, initialement présents dans le faisceau 8, qui ne subissent pratiquement pas de collisions avec les atomes d'argon et conservent également l'énergie $E_0$, l'énergie $\alpha E_0$ étant donc essentiellement caractéristique des ions $B^+$ résultant de la décomposition des ions $BF_2^+$.

B 8145.3 PV

La longueur L de la chambre 11 peut être prise égale au libre parcours moyen relatif à la section efficace de décomposition des ions $BF_2^+$, soit une longueur L de l'ordre de 3 à 30 cm.

Les moyens séparateurs 5 sont placés à la suite de la chambre 11 et consistent en un filtre électrostatique constitué par deux plaques de déflexion 15 et 16 électriquement conductrices, disposées de façon à permettre le passage entre elles du faisceau 8 à sa sortie de la chambre 11, l'une des plaques étant portée à une haute tension positive, l'autre à une haute tension négative.

Le filtre électrostatique permet d'effectuer une séparation énergétique entre les ions du premier groupe et les ions du second groupe. A la sortie de ce filtre, on obtient ainsi deux faisceaux : un premier faisceau 17 d'ions $B^+$, d'énergie $\alpha E_0$, et un second faisceau 18 constitué par les autres particules du faisceau 8, d'énergie $E_0$ (et donc moins déviées que les ions $B^+$ d'énergie $\alpha E_0$).

En toute rigueur, les ions $^{10}B^+$ et $^{11}B^+$ n'ont pas exactement la même énergie ($10E_0/(10+2 \times 19)$ pour les ions $^{10}B^+$ et $11E_0/(11+2 \times 19)$ pour les ions $^{11}B^+$) et sont donc séparés.

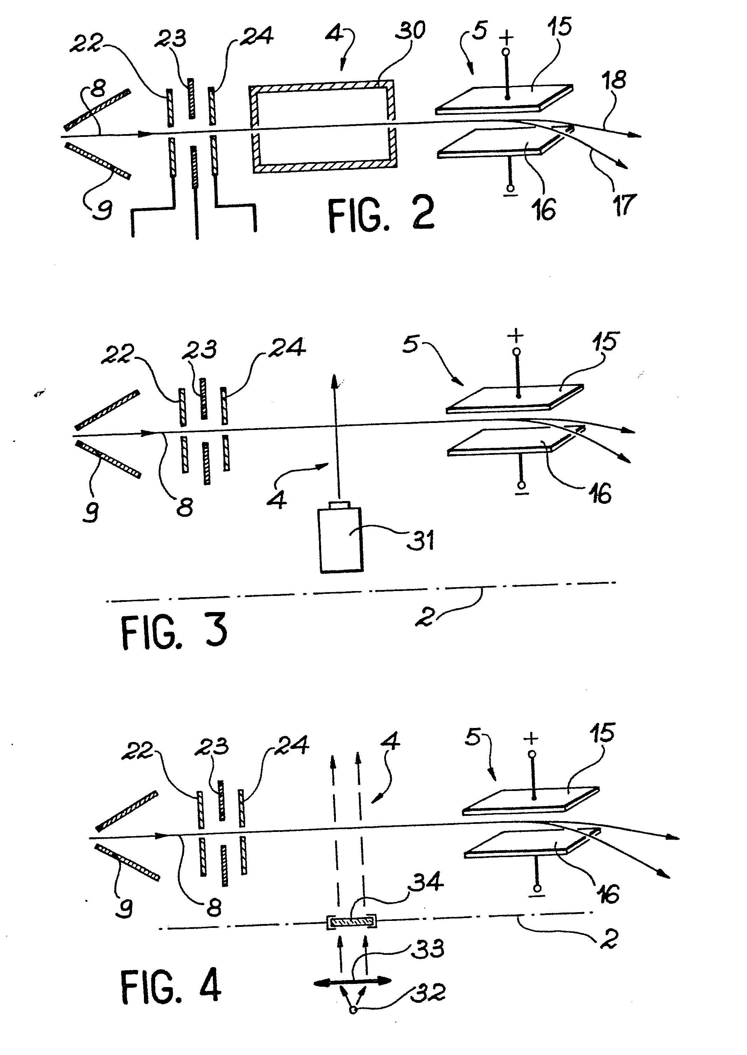

En outre, à sa sortie de la chambre 11, le faisceau 8 comprend également des particules notées X dans la réaction rappelée plus haut. Parmi ces particules notées X, certaines sont neutres et d'autres ionisées. A la sortie des moyens séparateurs, on obtient donc un autre faisceau 18a constitué par les particules notées X qui sont neutres et qui, n'interagissant donc pas avec les moyens séparateurs, poursuivent leur chemin en ligne droite. Les particules notées X qui sont chargées donnent lieu, après traversée des moyens séparateurs, à des sous-faisceaux non représentés, correspondant chacun à une particule d'énergie donnée : c'est par exemple le cas des particules $F^+$ dont l'énergie est égale à $19E_0/(11+2\times19)$. Ces considérations sur les particules notées X sont bien entendu valables pour les figures 2 à 6.

En ajoutant au dispositif selon l'invention une cible 19 disposée dans l'enceinte 2, sur la trajectoire du faisceau 17 d'ions $B^+$, on obtient un implanteur d'ions permettant d'implanter les ions $B^+$ du faisceau 17 dans la cible 19 par exemple constituée par un circuit intégré. Si nécessaire, on peut accélérer les ions $B^+$ du faisceau 17 préalablement à leur implantation, au moyen d'un champ électrique créé entre deux plaques 20 et 21 électriquement conductrices, disposées sur la trajectoire du faisceau 17, entre les moyens séparateurs 5 et la cible 19 et percées pour permettre le passage du faisceau 17 d'ions $B^+$, la première plaque 20 se trouvant sur le passage de ces ions étant portée à un potentiel électrique négatif par rapport à la plaque suivante 21.

Le cas échéant, on pourrait bien entendu disposer une autre cible sur la trajectoire du second faisceau 18 pour implanter, éventuellement avec une accélération préalable, les ions de ce second faisceau dans l'autre cible.

On peut éventuellement interposer des lentilles électrostatiques de focalisation du faisceau 8, entre l'électrode 9 et la chambre 11. On peut par exemple réaliser ces lentilles électrostatique de focalisation à l'aide de trois électrodes 22, 23, 24 adjacentes et percées pour permettre le passage du faisceau 8, l'électrode 23 étant interposée entre les électrode 22 et 24 et portée à un potentiel négatif par rapport à celles-ci, au moyen de générateurs de tension 25 et 26.

En outre, pour que les ions des faisceaux 8 et 17 ne soient pas soumis à des potentiels électriques flottants, on établit des liaisons électriques 27, 28 et 29 respectivement entre les électrodes 9 et 22, entre l'électrode 24 et la plaque 20 et entre la plaque 21 et la cible 19, cette dernière étant mise à la masse. Si l'on n'utilisait pas les lentilles de focalisation 22, 23, 24, les liaisons 27 et 28 seraient remplacées par une liaison électrique entre la source d'ions 6 et la plaque 20.

Sur la figure 2, on a représenté schématiquement et partiellement un autre mode de réalisation particulier du dispositif objet de l'invention dont la seule différence avec le mode de réalisation représenté sur la figure 1 réside dans le fait que les moyens 4 de décomposition sont maintenant constitués par un plasma confiné par des moyens connus non représentés, dans une enceinte 30 qui est disposée et percée d'ouvertures de la façon indiquée plus haut à propos de l'enceinte 11. Les ions $BF_2^+$ du faisceau 8 interagissent alors avec les particules du plasma pour donner des ions $B^+$, les autres ions du faisceau 8 n'interagissant pratiquement pas avec le plasma.

Sur la figure 3, on a représenté schématiquement et partiellement un autre mode de réalisation particulier du dispositif objet de l'invention dont la seule différence avec le mode de réalisation représenté sur la figure 1 réside dans le fait que les moyens de décomposition 4 sont maintenant constitués par un flux de photons X ou γ émis par un générateur approprié 31, ce flux étant envoyé, par exemple transversalement, sur une partie du faisceau 8 comprise entre les moyens séparateurs 5 et l'électrode 9 (ou les lentilles électrostatiques 22, 23, 24 lorsqu'elles existent). Comme précédemment, l'interaction des photons X

ou $\gamma$ n'a pratiquement lieu qu'avec les ions $BF_2^+$ du faisceau 8 qui se décomposent alors pour donner des ions $B^+$.

Sur la figure 4, on a représenté schématiquement et partiellement un autre mode de réalisation particulier du dispositif objet de l'invention dont la seule différence avec le mode de réalisation représenté sur la figure 3 réside dans le fait que le flux de photons X ou $\gamma$ est remplacé par un flux 4 de photons du domaine visible ou ultraviolet, de longueur d'onde appropriée, émis par une source 32 munie d'une optique 33 et extérieure à l'enceinte 2, la lumière issue de la source 32 traversant alors ladite enceinte 2 par un hublot 34, pour arriver, transversalement, sur le faisceau 8 et n'interagir alors pratiquement qu'avec les ions $BF_2^+$ de ce faisceau 8.

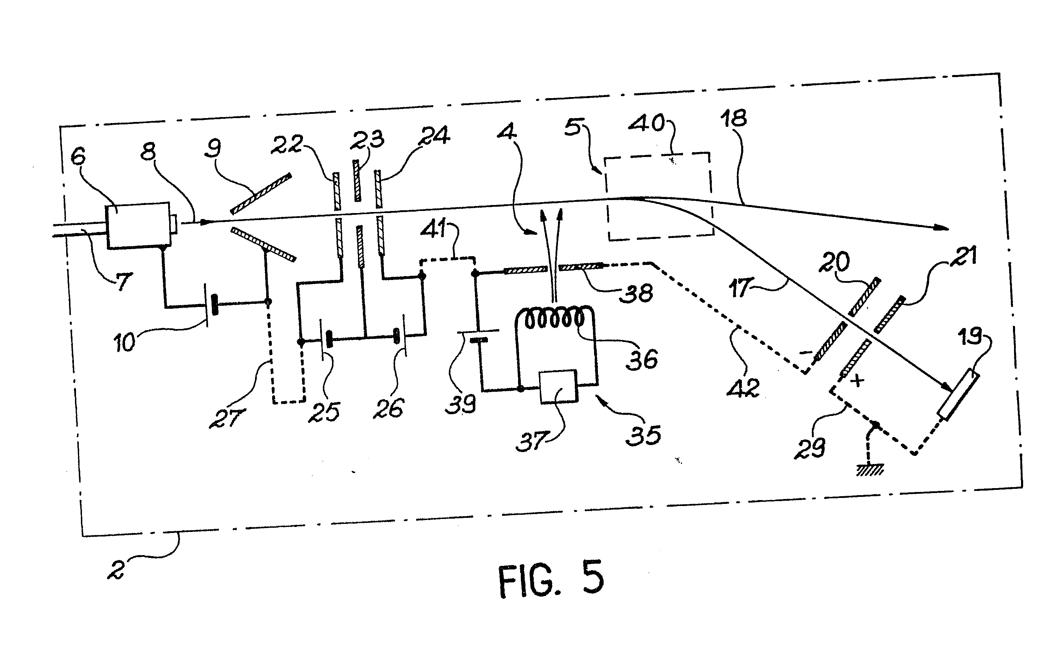

Sur la figure 5, on a représenté schématiquement un autre mode de réalisation particulier du dispositif objet de l'invention qui diffère seulement du mode de réalisation représenté sur la figure 1 par le fait que les moyens de décomposition 4 sont maintenant constitués par un faisceau d'électrons d'énergie convenable, n'interagissant pratiquement qu'avec les ions $BF_2^+$ du faisceau 8 qui se décomposent alors en donnant des ions $B^+$, et par le fait que les moyens séparateurs 5 sont constitués par un filtre 40 à champs électrique et magnétique.

Le faisceau d'électrons 4 est émis par une source d'électrons 35 comportant un filament 36 émetteur d'électrons lorsqu'il est chauffé à l'aide d'un générateur de courant 37, et une électrode percée 38, prévue pour être traversée par les électrons issus du filament 36. L'électrode 38 est portée à un potentiel électrique positif par rapport au filament 36, au moyen d'un générateur de tension continue 39, de manière à accélérer les électrons issus du filament 36. La source 35 d'électrons est bien entendu orientée de façon à envoyer les électrons accélérés qu'elle produit sur le faisceau d'ions 8, par exemple transversalement à celui-ci, sur une partie dudit faisceau comprise entre les moyens séparateurs 5 et l'électrode 9 (ou les lentilles électrostatiques 22, 23, 24 lorsqu'elles existent).

Les moyens séparateurs 5, constitués par un filtre 40 à champs électrique et magnétique, par exemple un filtre à champs croisés, sont disposés comme on l'a indiqué dans la description de la figure 1 à propos du filtre électrostatique 15, 16 et permettent encore de trier les ions du faisceau 8 pour séparer celui-ci en deux faisceaux 17 et 18 correspondant respectivement aux ions $B^+$ résultant de la décomposition des ions $BF_2^+$ par le faisceau d'électrons 4 et au reste du faisceau 8 n'ayant pas interagi avec ce faisceau d'électrons.

Certes, le filtre 40 comporte des moyens magnétiques mais ceux-ci sont beaucoup moins complexes ou encombrants que les moyens magnétiques de séparation isotopique de masse.

Les liaisons électriques 27 et 29 décrites plus haut subsistent dans le dispositif représenté sur la figure 5 mais la liaison 28 est supprimée. Elle est remplacée par une liaison électrique 41 entre l'électrode 24 et l'électrode 38, et par une liaison électrique 42 entre l'électrode 38 et la plaque 20. Si l'on n'utilisait pas les lentilles de focalisation 22, 23, 24, les liaisons 27 et 41 seraient remplacées par une liaison électrique entre l'électrode 9 et l'électrode 38.

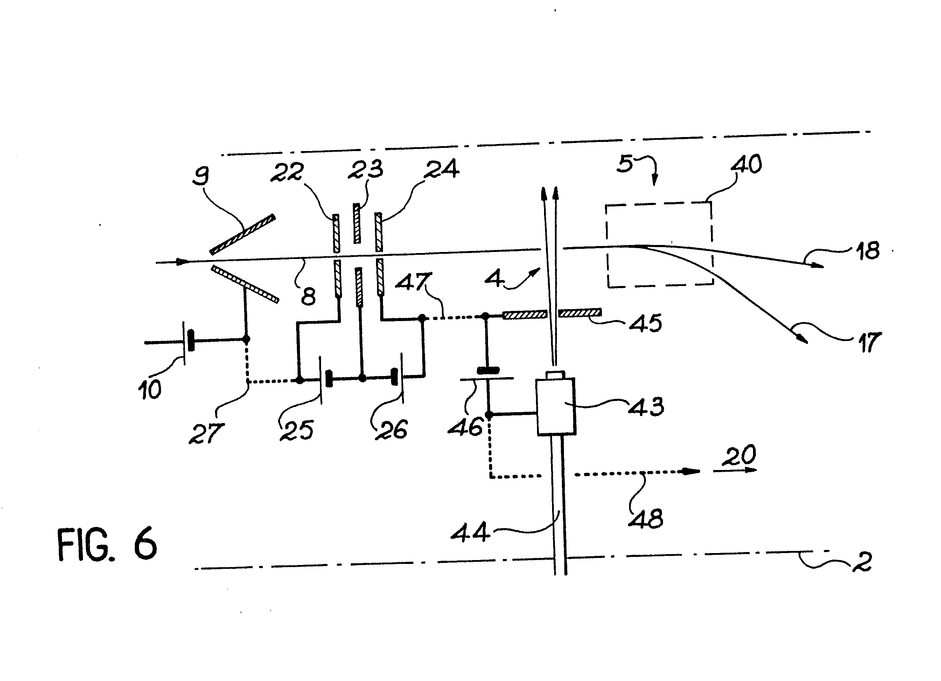

Sur la figure 6, on a représenté schématiquement et partiellement un autre mode de réalisation particulier du dispositif objet de l'invention, qui diffère seulement du dispositif représenté sur la figure 5 par le fait que les moyens de décomposition 4 sont maintenant constitués par un faisceau d'ions d'énergie convenable, qui n'interagissent pratiquement qu'avec les ions $BF_2^+$ du faisceau 8 pour que ceux-ci se décomposent en donnant des ions $B^+$, et qui sont par exemple des ions $He^+$ émis par une source d'ions 43 alimentée en hélium au moyen d'un conduit 44. Le faisceau d'ions $He^+$ est accéléré à sa sortie de la source 43 par une électrode 45 percée pour permettre le passage des ions $He^+$ et portée à un potentiel négatif par rapport à la source 43, au moyen d'un générateur de tension continue 46. Le faisceau d'ions $He^+$ ainsi accéléré est envoyé, par exemple transversalement, sur une partie du faisceau 8 comprise entre les moyens séparateurs 5 et l'électrode 9 (ou les lentilles 22, 23, 24 lorsqu'elles existent).

Les liaisons électriques 27 et 29 représentées sur la figure 1 sont toujours présentent mais la liaison 28 est supprimée. Elle est remplacée par une liaison électrique 47 entre les électrodes 24 et 45 et par une liaison électrique 48 entre la source 43 et la plaque 20. Si l'on n'utilisait pas les lentilles de focalisation 22, 23, 24, les liaisons 27 et 48 seraient remplacées par une liaison électrique entre l'électrode 9 et la source 43.

Au lieu d'utiliser le composé $BF_3$ pour réaliser le faisceau 17 d'ions $B^+$, on pourrait utiliser le composé $BCl_3$ qui, dans une source d'ions, fournit des ions $BCl_2^+$ aptes à se décomposer, par exemple par interaction avec des atomes d'argon, pour donner les ions $B^+$.

En outre, l'utilisation du dispositif objet de l'invention n'est pas limitée à la production d'un faisceau d'ions $B^+$ : ce dispositif permet d'obtenir des faisceaux d'autres espèces ionisées telles que $P^+$ (à partir d'ions $PF_2^+$ eux-mêmes obtenus à partir du composé $PF_3$) ou $As^+$ (obtenu à partir d'ions $AsF_2^+$ eux-mêmes obtenus à partir du composé $AsF_3$).

L'invention s'applique de façon générale à la production d'un faisceau de toute espèce (atome, molécule) ionisée admettant un composé ionisé qui peut être formé dans une source d'ions et extrait de celle-ci, qui est de plus apte à se décomposer pour donner l'espèce considérée sous forme ionisée et qui, de préférence, présente une grande section efficace d'interaction avec des atomes neutres, des ions, des électrons ou des photons.

B 8145.3 PV

0155875 .

## REVENDICATIONS

1. Dispositif de production d'ions d'une espèce déterminée, caractérisé en ce qu'il comprend :
- des moyens-source (3), prévus pour créer un faisceau (8) d'ions isoénergétiques comprenant des ions qui contiennent l'espèce déterminée et sont aptes à se décomposer en donnant des ions constitués de l'espèce déterminée sous forme ionisée,
- des moyens de décomposition (4), prévus pour interagir préférentiellement avec les ions contenant l'espèce déterminée et décomposer ceux-ci en faisant apparaître les ions constitués de l'espèce déterminée sous forme ionisée, et
- des moyens séparateurs (5), prévus pour effectuer une séparation énergétique entre les ions constitués de l'espèce déterminée sous forme ionisée et le reste du faisceau.

2. Dispositif selon la revendication 1, caractérisé en ce que les moyens de décomposition (4) comprennent un gaz à basse pression ou un plasma, contenu dans un domaine (11, 30) traversé par le faisceau d'ions.

3. Dispositif selon la revendication 1, caractérisé en ce que les moyens de décomposition (4) comprennent un flux de particules, dirigé vers le faisceau d'ions.

4. Dispositif selon l'une quelconque des revendications 1 à 3, caractérisé en ce que les moyens séparateurs (5) comprennent au moins un filtre électrostatique (15, 16).

5. Dispositif selon l'une quelconque des revendications 1 à 3, caractérisé en ce que les moyens séparateurs (5) comprennent au moins un filtre à champs électrique et magnétique (40).

B 8145.3 PV

15

0155875

6. Application du dispositif selon l'une quelconque des revendications 1 à 5, à l'implantation ionique.

B 8145.3 PV

FIG. 1

FIG. 2

FIG. 3

FIG. 4

FIG. 5

0155875

FIG. 6

0155875

**Office européen
des brevets**

## RAPPORT DE RECHERCHE EUROPEENNE

EP  85 40 0333

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl.4) |
|---|---|---|---|
| Y | US-A-3 786 359 (KING) * Figure; colonne 1, lignes 38-63; colonne 2, ligne 4 - colonne 3, ligne 45 * | 1,2 | H 01 J 37/317 H 01 J 37/05 H 05 H 3/02 |
| A | | 4,5,6 | |
| Y | FR-A-2 261 802 (DEVIENNE) * Figures 2 et 3; page 1, ligne 37 - page 3, ligne 3; page 10, ligne 19 - page 11, ligne 28 * | 1,2 | |

|  | DOMAINES TECHNIQUES RECHERCHES (Int. Cl.4) |
|---|---|
|  | H 01 J 37 H 05 H 3 B 01 D 59 |

Le présent rapport de recherche a été établi pour toutes les revendications

| Lieu de la recherche | Date d'achèvement de la recherche | Examinateur |
|---|---|---|
| LA HAYE | 20-05-1985 | SCHAUB G.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03.82